# EUROPEAN PATENT APPLICATION

(11) **EP 2 506 301 A2**
(43) Date of publication of application: **03.10.2012**
(21) Application number: 12160932.5
(22) Date of filing: 23.03.2012
(51) Int. Cl.: H01L 25/075, H05K 1/18, H01L 33/64, H01L 33/56

(54) **Luminous-body flexible board and luminous device**

(30) Priority: 31.03.2011 JP 2011077001
(71) Applicant: Yamaichi Electronics Co., Ltd., Ota-ku Tokyo 143-8515 (JP)
(72) Inventor: Sekine, Noriaki, Ohta-ku, Tokyo 143-8515 (JP)
(74) Representative: Uchida, Kenji

(57) **Abstract**

A luminous-body flexible board includes a flexible board (10) including a metal substrate (11) of a bendable plate, an insulating layer (12) of liquid crystal polymer of which one surface is joined directly to the metal substrate (11) and a conductor layer (13) joined to the other surface of the insulating layer (12) and formed in a wiring pattern. The flexible board (10) further has a plurality of cavities (14) dented on a side of the conductor layer (13) and protruded on a side of the metal substrate (11) of the flexible board (10), being arranged in juxtaposition and configured to be mounted a luminous element (31) respectively therein.

## Description

### Technical Field

The present invention relates to a luminous-body flexible board on which a luminous element, such as light-emitting diode (LED), is mounted, and a luminous device.

### Background art

A luminous device has been widely used in various lamps; display devices, which are used for transmitting information such as characters, symbols and images or for decorative illumination; illuminating devices, which are used in floodlights, backlights for liquid-crystal displaying, and the like. The luminous body, which is a typical surface mount device (SMD), has the following structure: a luminous element thereof is mounted to one principal plane of a plate-like insulating substrate, and then sealed with a resin; and electrodes of the luminous element become connected to lines on the insulating substrate, or to a land thereof, by means of wire bonding or the like. In this case, the lines are disposed on one principal plane (top surface) of the insulating substrate, and then pulled out to the other principal plane (back surface). Then, for example, the luminous body is so mounted as to be electrically connected to the circuit wiring of a circuit board, such as a printed circuit board (PCB), or the like.

In other cases, in a conventional luminous-element package, instead of the above lines, a lead frame is used. Moreover, in order to make it easier to increase the luminance of the luminous body, a ceramics mold having a bowl-shaped cavity is used, and, in this case, a luminous element may be so structured as to be placed in the cavity. Here, on a side face of the cavity, a light reflection layer made of a conductor is formed.

### (Related-Art Documents)

Japanese Patent Application Laid-Open Publication No. 2008-305834
Japanese Patent Application Laid-Open Publication No. 9-45965

In recent years, for example, illuminating devices such as floodlights that use LEDs have been increasingly becoming higher in luminance of white light and gaining higher light intensity. However, conventional luminous bodies, including those described above, may not be able to ensure heat-release performance sufficient enough to transfer the heat generated from the LEDs as higher power is required for higher luminance or higher light intensity. If it is not possible to release heat in a highly efficient manner, the characteristics of the LEDs are more likely to deteriorate over time. As the luminous efficiency of the LEDs becomes diminished, the luminous bodies could end up being short-lived. Moreover, on the boards on which the luminous elements are mounted, for example, the insulating, heat-resisting and other properties of the insulating substrates are more likely to deteriorate due to light irradiation. Because of the above, it is difficult to realize a highly-reliable luminous body.

Moreover, for a display device or illuminating device, what is required is a flexible luminous body that can be changed into any shape, in order to make it possible to control plane emission of light, for example, from a spherical surface, a curved surface such as cylindrical surface, or a two-dimensional surface with a high degree of accuracy.

The primary object of the present invention is to provide a luminous-body flexible board that makes possible a highly-reliable luminous body having heat-release performance sufficient enough to handle higher light intensity, and the luminous body. Another object is to provide a luminous-body flexible board that is excellent in mass productivity, for example making it possible to provide low-cost luminous bodies having higher luminance or higher light intensity.

### Disclosure of Invention

According to an embodiment of the present invention, a luminous-body flexible board comprises a flexible board including a metal substrate of a bendable plate, an insulating layer of liquid crystal polymer of which one surface is joined directly to the metal substrate and a conductor layer joined to the other surface of the insulating layer and formed in a wiring pattern. The flexible board has a plurality of cavities dented on a side of the conductor layer and protruded on a side of the metal substrate, being arranged in juxtaposition and configured to be mounted a luminous element respectively therein.

### Brief Description of Drawings

FIG. 1 is a partial cross-sectional view showing one example of a first embodiment.
FIG. 2 is a partial cross-sectional view showing another example of the first embodiment.
FIGS. 3 (a) to (e) are cross-sectional views showing one example of a production method of the first embodiment.
FIGS. 4 (a) and (b) are diagrams illustrating a draw forming process of the first embodiment: (a) is an explanatory cross-sectional view of a draw forming machine; (b) is a cross-sectional view taken along line X-X of (a).
FIGS. 5 (a) and (b) are schematic cross-sectional views illustrating a modified example of a flexible board according to the first embodiment.
FIGS. 6 (a) and (b) are cross-sectional views showing two examples of a single luminous body according to the second embodiment.
FIGS. 7 (a) and (b) are cross-sectional views showing two other examples of a single luminous device according to the second embodiment.
FIGS. 8 (a) to (c) are explanatory top views showing a plurality of examples of a luminous-body flexible board according to the second embodiment.
FIGS. 9 (a) and (b) are schematic side views illustrating plane emission of light by a luminous-body flexible board according to the second embodiment.
FIGS. 10 (a) to (c) are cross-sectional views showing one example of a production method of a luminous device according to the second embodiment.

### Detailed Description

Hereinafter, embodiments of the present invention will be described with reference to the accompanying drawings. The same, or similar, portions are denoted by the same reference symbols, and some of overlapping descriptions will be omitted. The drawings are schematic in nature, showing the ratio of each dimension or the like that is different from actual one.

### (First Embodiment)

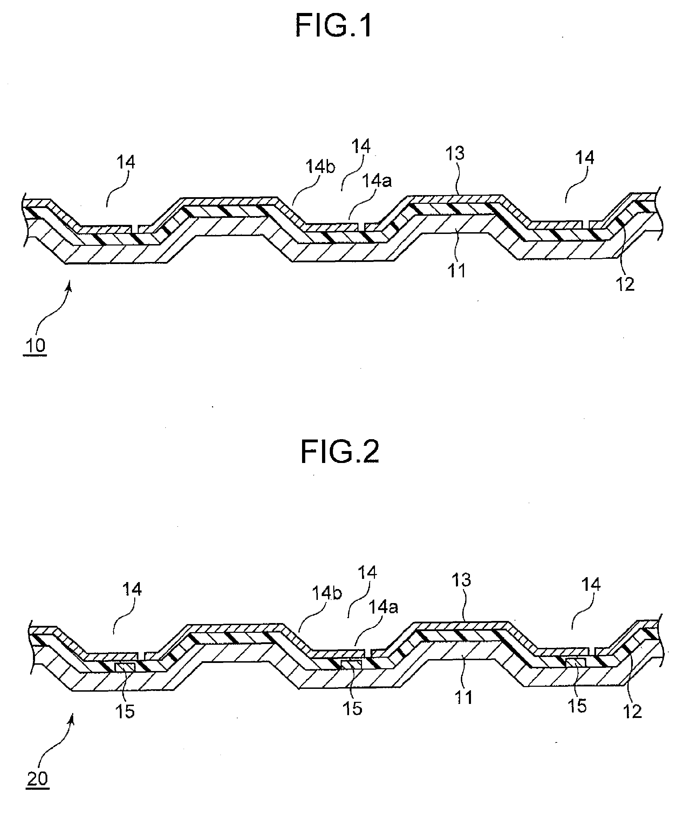

A luminous-body flexible board according to an embodiment, as well as a production method thereof, will be described with reference to FIGS. 1 to 5.

As shown in FIG. 1, a flexible board 10 constituting the luminous-body flexible board contains a substrate 11 of a plate-like, bendable metal, a liquid crystal polymer insulating layer 12 of which a lower surface is joined to the substrate 11, and a conductor layer 13 in which a wiring pattern is formed is disposed on an upper surface of the liquid crystal polymer insulating layer 12. In predetermined regions of a laminated plate including the metal substrate 11, the liquid crystal polymer insulating layer 12 and the conductor layer 13, a plurality of cavities 14 are provided in juxtaposition in line or at random. As for the cavities 14, dented portions 14A are provided on the conductor layer 13's side of the laminated plate, or the upper surface thereof, and protruded portions 14B are provided on the metal substrate 11's side of the laminated plate, or the lower surface thereof. In this manner, the cavities 14 are arranged so as to have concave and convex shapes on the upper and lower surfaces of the laminated plate. The metal substrate 11 and the liquid crystal polymer insulating layer 12, as well as the liquid crystal polymer insulating layer 12 and the conductor layer 13, are directly joined together without adhesive agents.

In a flexible board 20 shown in FIG. 2, in regions corresponding to the cavities 14 of the flexible board 10 illustrated in FIG. 1, flat bumps 15, which are higher in thermal conductivity than the liquid crystal polymer insulating layer 12, are provided on the principal surface of the metal substrate 11. The bumps 15 are embedded in the liquid crystal polymer insulating layer 12 with a predetermined thickness, and are so formed as to be closer to the conductor layer 13 than the other area.

The metal substrate 11 is a sheet of metal, such as aluminum (Al), copper (Cu) or Al-Cu alloy, which is soft and spreadable. The thickness of the metal substrate 11 is, for example, about 50 µm to 300 µm.

The liquid crystal polymer insulating layer 12 has heat resistance, and is preferably made of a thermoplastic resin that is high in light reflectivity. The thickness of the liquid crystal polymer insulating layer 12 is about 15 µm to 100 µm. What is preferred is a film-like liquid crystal polymer insulating layer 12 that does not show little change in liquid crystalline property in a thermo-compression bonding process to the metal substrate 11 or in a draw forming process in which the above cavities 14 are formed, which will be described along with a method of producing a luminous-body flexible board.

As such a kind of liquid crystal polymer, for example, there is a thermotropic liquid crystal polymer that shows liquid crystallinity even in a molten state. Specifically, thermotropic liquid crystalline polyester and thermotropic liquid crystalline polyester amide can be listed. Moreover, for example, there are multi-axis oriented thermoplastic polymers, such as Xydar (Trade Name; manufactured by Dartco) or Vectra (Trade Name; manufactured by Clanese). Moreover, liquid crystal polymers that have been modified by adding and mixing other insulating resins may also be available. The following are shown as examples: Vecstar FA type (Melting point: 285 °C), Vecstar CT type (Melting point: 310 °C), BIAC film (Melting point: 335 °C), and the like.

A thermal expansion coefficient of the liquid crystal polymer is 17 to 18 × 10⁻⁶/°C, and is closer to thermal expansion coefficients of bendable metal substrates of Cu, Al and stainless steel. The liquid crystal polymer is directly joined to such a metal by means of thermo-compression bonding, and a laminated body is formed as a result.

In that manner, the laminated body is made. Therefore, even if a liquid crystal polymer insulating layer is made thinner, cracks do not appear during a draw forming process. The thin insulating layer structure helps to reduce thermal resistance, thereby increasing the heat-release performance in a way that efficiently conducts heat from a mounted luminous element e.g., LED, to the metal substrate.

The liquid crystal polymer insulating layer is white in color, enabling the luminous element to better reflect light.

As for the conductor layer 13, the patterning of metallic foil such as Cu foil is performed, or a plated layer is formed on a surface of the metallic foil; the conductor layer 13 works as die lands, on which luminous elements are mounted, circuit wiring, external terminals and the like. A required pattern of the conductor layer 13 is disposed on the liquid crystal polymer insulating layer 12 in a manner electrically connected to surface mounted components such as luminous elements, which will be described below. In this case, the thickness of the metallic foil is for example set appropriately to about 10 µm to 35 µm. For the plated layer, for example, a single layer of gold (Au), silver (Ag) or nickel (Ni), or a composite layer of Ni/Au or Ni/Ag is preferred. It is preferred that the above conductor layer 13 and the plated layer be spreadable.

The cavities 14 serve as regions where surface mounted components, i.e., luminous elements, are mounted on bottom-face portions 14a, which are in the shape of a dish and exist inside the dented portions 14B of the cavities 14. In this case, side-face portions 14b are inclined at a predetermined angle so as to spread in a direction toward the outside of the cavities 14. The inclination angle is appropriately determined so as to have a required shape. In this manner, the cavities 14 are, from the upper to the lower surface of the flexible board 10, in the shape of an inverted frustum, such as an inverted frustum of circular cone, an inverted frustum of elliptical cone or an inverted frustum of pyramid. The depth thereof is determined appropriately according to the dimensions of the surface mounted components. Meanwhile, for example, the metal substrate 11 protrudes in the shape of a frustum.

Bumps 15 are so designed as to make it easier for the heat generated from surface mounted components, such as luminous elements, to be released. The bumps 15, i.e., a flat plate, are provided at locations corresponding to the positions of the bottom-face portions 14a of the cavities 14, where surface mounted components, such as luminous elements, are mounted. For the bumps 15, a material that is higher in thermal conductivity than the liquid crystal polymer insulating layer 12 is used; a conductor material, a mixture of a thermosetting resin and a metal, or the like is preferred. The thickness of the bumps 15 is determined appropriately, with the thickness of the liquid crystal polymer insulating layer 12 taken into consideration. Incidentally, as described later, depending on the way the surface mounted components such as luminous elements are energized, the bumps 15 may pass through the liquid crystal polymer insulating layer 12 and be electrically connected to external connection terminals of the surface mounted components.

The following describes one example of a production method of a flexible board. The following description is of the flexible board 20 illustrated in FIG. 2.

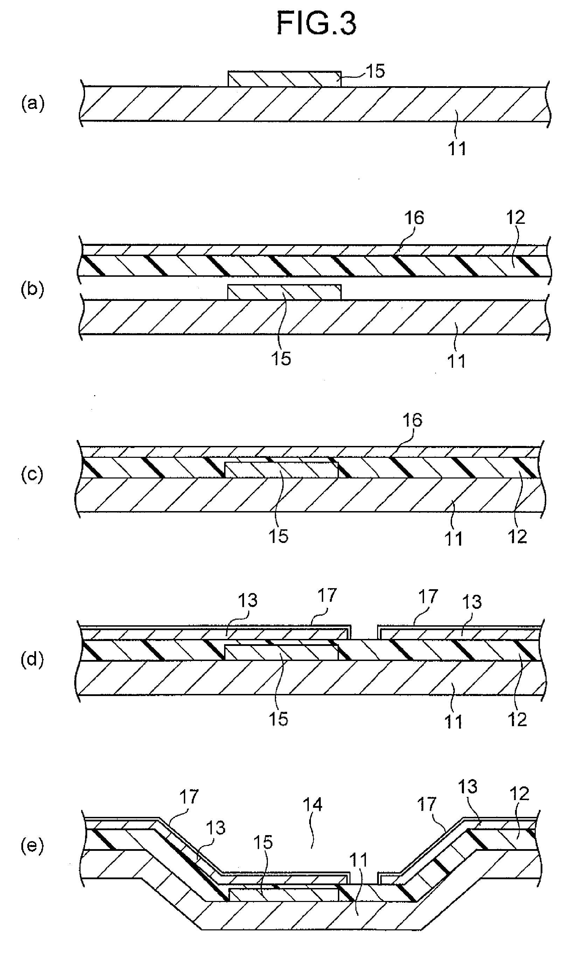

As shown in FIG. 3 (a), for example, the metal substrate 11, which has a thickness of about 100 µm and is made of Al, is prepared.

Then, for example, by means of screen printing or the like, a thermally conductive paste is attached to one principal plane of the metal substrate 11, and a bump 15 whose upper portion is flat is formed. In this case, for example, the thermally conductive paste used is preferably made by dispersing metal powder, such as Ag, Cu or Au, into a binder resin, which is made of a thermosetting resin.

Then, as shown in FIG. 3 (b), a liquid crystal polymer film 12 with a thickness of for example about 50 µm, which serves as a liquid crystal polymer insulating layer 12, and metallic foil 16 with a thickness of for example about 20 µm are placed onto the metallic substrate 11. Then, a predetermined heat and pressure process, or hot pressing, is performed on the metal substrate 11, the liquid crystal polymer film 12 and the metallic foil 16. In this case, the heating temperature is set lower than a glass transition point Tg or melting point Tm of the liquid crystal polymer. It is particularly preferred that the orientation of the liquid crystal polymer be not changed at the heating temperature. The pressurization pressure is appropriately determined within a range of about 30 to 100 kgf/cm². Incidentally, it is preferred that the hot pressing take place under a reduced-pressure atmosphere.

In that manner, as shown in FIG. 3 (c), the metal substrate 11, the liquid crystal polymer film 12 and the metallic foil 16 are turned into a laminated body by means of thermo-compression bonding. As a result, the bump 15 becomes embedded in the liquid crystal polymer 12 in such a way that the upper portion thereof approaches and is positioned in the following manner: about 5 to 10 µm away from the metallic foil 16.

Then, as shown in FIG. 3 (d), the patterning of the metallic foil 16 is performed to produce a wiring pattern 13. A plated layer 17 is then formed on a surface of the wiring pattern 13.

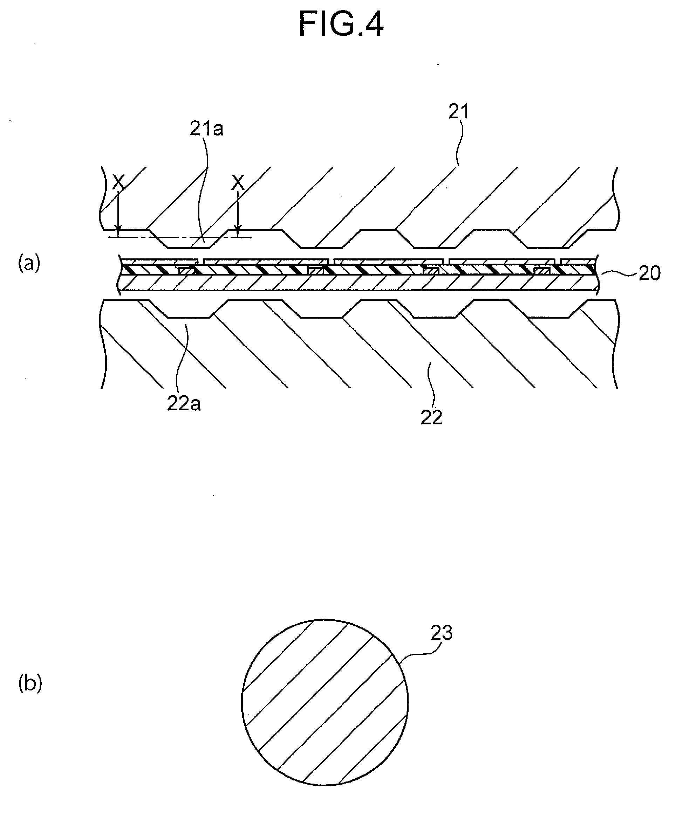

Then, on the laminated body's flexible board that has been formed as shown in FIG. 3 (d), a draw forming process is performed, creating required cavities 14 as shown in FIG. 3 (e). In the draw forming process, hot pressing of a plate-like flexible board is performed with an upper punch (puncher) 21 and a lower punch (die) 22 as shown in FIG. 4 (a), for example. The temperature of the hot pressing is preferably less than or equal to the temperature of hot pressing for the thermo-compression bonding illustrated in FIG. 3 (c), which is aimed at preventing the occurrence of a separation between the metal substrate 11, liquid crystal polymer insulating layer 12 and conductor layer 13 that are joined together. In the hot pressing, in order to keep the metal substrate 11 and the like from being oxidized, the draw forming process is preferably carried out under an inert gas or reducing gas atmosphere. Moreover, in the draw forming process, a vacuum forming method, a pressure forming method may be employed.

Metal patterns for the upper punch 21 and lower punch 22 used in the draw forming process may be formed into various shapes according to the required shape of the cavities 14. FIG. 4 (b) shows the case where an X-X cut section 23 of a male portion 21a of the upper punch 21 is in a circular shape. Accordingly, a female portion 22a of the lower punch 22 is also in a circular shape.

In the draw forming process, parts of the metal substrate 11 and conductor layer 13 in regions where the cavities 14 are formed are subjected to tensile stress or partial compression stress. In this case, since the metal substrate 11 and the conductor layer 13 are soft and spreadable, the metal substrate 11 and the conductor layer 13 are bendable and plastically-deformed, thereby easily mitigating the tensile or compression stress in the draw forming process. As a result, the residual stress or residual strain stemming from the above becomes smaller, and it is possible to obtain a highly-reliable luminous-body flexible board. Incidentally the pattern shape of the conductor layer 13 may be so devised that the rupture or the like associated with the above stress can be easily avoided.

According to the above-described production method, the luminous-body flexible board 20 illustrated in FIG. 2 can be produced.

The luminous-body flexible board of the present embodiment has a structure where the liquid crystal polymer insulating layer 12 and the conductor layer 13 are stacked on the flexible, soft metal substrate 11 and are joined together integrally. In predetermined regions, a plurality of cavities 14 are formed and arranged. As a result, the heat generated from the surface mounted components such as luminous elements mounted in the cavities 14 can be easily released through the metal substrate 11.

Incidentally, the side-face portions 14b of the cavities 14 are inclined at a predetermined angle so as to spread in a direction toward the outside of the cavities 14, thereby increasing the surface area of the metal substrate 11 and enabling the heat to be released in an efficient manner. Moreover, even though the luminous-body flexible board has a large number of cavities 14, the liquid crystal polymer insulating layer 12 and the conductor layer 13 are stacked on the metal substrate 11. Therefore, when a large number of cavities 14 are formed, the metal substrate 11 functions as a reinforcing plate, and therefore prevents cracks or any other troubles from appearing on the liquid crystal polymer insulating layer 12.

Therefore, according to the present embodiment, with the use of a thin film on which cracks could appear when a liquid crystal polymer film alone is subjected to hot pressing, it is possible to obtain an insulating layer having no cracks.

The integral joining of the flexible board can be easily performed by typical hot pressing. A plurality of cavities 14 arranged can be easily formed by a typical draw forming process with the use of the metal patterns of a desired shape. Thus, the flexible board is excellent in mass productivity, and can be easily made at low costs.

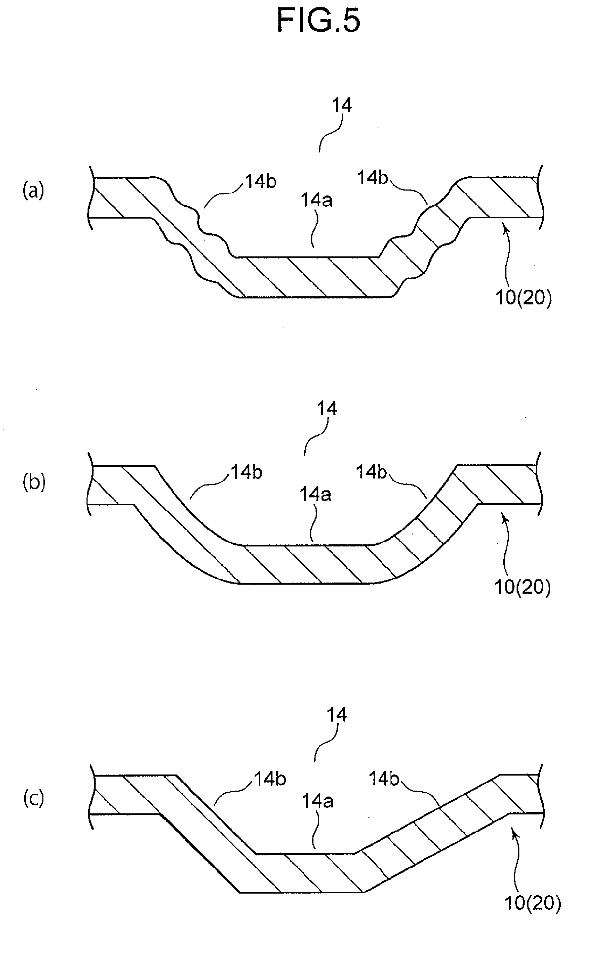

The following describes another modified example of the luminous-body flexible board with reference to FIG. 5. FIG. 5 is a schematic, enlarged cross-sectional view of a dish shaped cavity 14, which has been described along with the flexible boards 10 and 20.

In the case of the flexible board shown in FIG. 5 (a), the side-face portions 14b of the cavity 14 on the flexible board 10 or 20 are so formed as to have a rough surface of a corrugated pattern, for example. The rough surfaces are formed on the surfaces of the metal substrate 11, the liquid crystal polymer insulating layer 12 and the conductor layer 13. As a result, the surface area of the metal substrate 11 becomes larger and makes it possible to release heat in a more efficient manner. The diffusion of the light emitted from a luminous element mounted on a bottom-face portion 14a could more easily occur due to the diffused reflection of light from the rough surfaces of the side-face portions 14b, suppressing the directivity of outward light emission. Accordingly, the emission angle dependence of light emission intensity from a luminous element decreases, and the uniformity of forward illumination improves. The above rough surface may be formed to be rough enough to make the diffused reflection of visible light possible. Furthermore, the cavity 14 is formed in a corrugated pattern, contributing to an increase in strength. Therefore, it is possible to prevent the cavity 14 from being deformed.

In the case of the flexible board shown in FIG. 5 (b), the surfaces of the side-face portions 14b of the cavity 14 on the flexible board 10 or 20 are in the shape of a concave surface.

Accordingly, the diffusion of the light emitted from a luminous element on the bottom-face portion 14a is curbed, leading to an increase in outward directivity. In this case, for example, it becomes easier for the light to exit in a direction perpendicular to the bottom-face portion 14a, and it becomes possible to increase the light emission intensity in the direction.

In the case of the flexible board shown in FIG. 5 (c), the surfaces of the side-face portions 14b of the cavity 14 on the flexible board 10 or 20 both are planes that are inclined at a predetermined angle. However, unlike the cases of FIGS. 1 and 2, the inclination angles are different and uneven in such a way that the side-face portions 14b are more inclined in a direction toward the outside. Therefore, it is possible to concentrate the outgoing light, which comes from a luminous element, in a predetermined oblique direction.

In a draw forming process used in the above modified example, the metal patterns of the upper punch 21 and the lower punch 22 can be formed into various shapes according to the required shape of the cavity 14 illustrated in FIG. 5. For example, the X-X cut section 23 shown in FIG. 4 (b) may be in an elliptical shape; or alternatively, the X-X cut section 23 may be formed into the shape of an arbitrary closed surface, triangle, square, or polygon.

### (Second Embodiment)

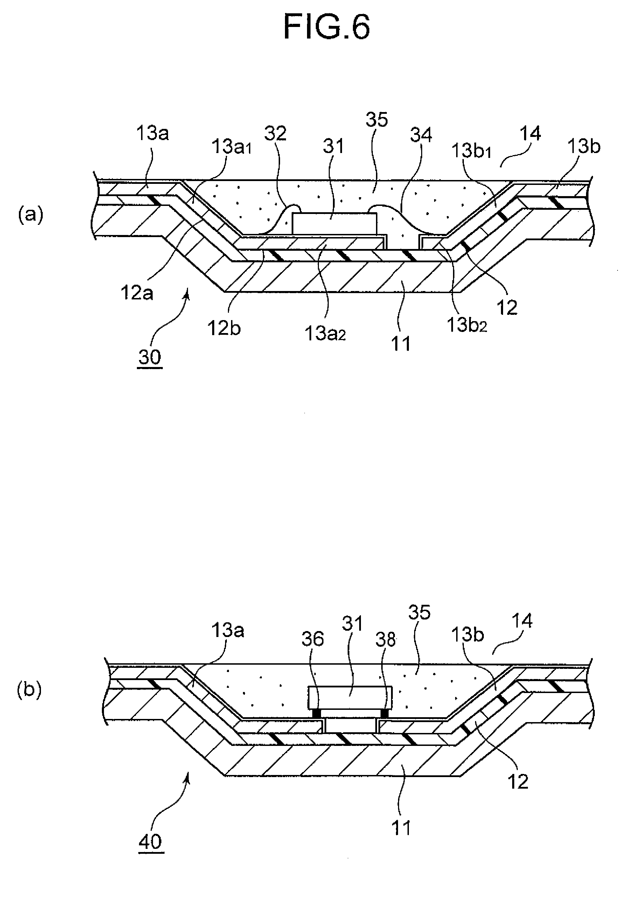

The second embodiment will be described as to a luminous device, which uses a luminous-body flexible board of the present invention, and a production method thereof, with reference to FIGS. 6 to 10.

A luminous device shown in FIG. 6 is a single luminous device, which is obtained as a luminous element is mounted in a region of a cavity 14 of the flexible board 10 of the first embodiment and then divided into individual pieces of luminous-body flexible board or assembly with a plurality of luminous elements. The conductor layer 13 is placed so as to extend on a side-face portion 12a and bottom-face portion 12b of the liquid crystal polymer insulating layer 12 of the cavity 14. A first wiring pattern 13a includes a lead portion 13a1 and a mount portion 13a2. The lead portion 13a1 is disposed on the side-face portion 12a, and the mount portion 13a2 on the bottom-face portion 12b.

A second wiring pattern 13b includes a lead portion 13b1, and is so disposed as to extend onto a side-face portion 12a from the wiring of a plane domain. The tip of the lead portion 13b1 extends to the bottom-face portion 12b, forming an extending terminal 13b2.

In a luminous device 30 shown in FIG. 6 (a), on the mount portion 13a2 of the first wiring pattern 13a of the conductor layer 13, a luminous element 31 is mounted face-up. One of two electrodes (not shown), which are external connection terminals provided on the surface of the luminous element 31, is connected to the first wiring pattern 13a through a first wire 32, and the other electrode is bonded to the second wiring pattern 13b through a second wire 34. The mount portion 13a2 of the first wiring pattern 13a at an end of the luminous device 30 and the terminal 13b2 of the second wiring pattern 13b serve as terminals of the luminous device.

With the use of a translucent resin material, a sealing resin 35 is formed in the cavity 14. The luminous element 31, the first wire 32, the second wire 34, and the like are mounted in the cavity 14 and sealed with the sealing resin 35.

Meanwhile, in the case of a luminous device 40 shown in FIG. 6 (b), a luminous element 31 is so mounted as to have a flip chip structure. That is, one of two electrodes (not shown) of the luminous element 31 is connected to a terminal 13a2 of a first pattern 13a through a first conductor bump 36, which is made of an Au-Sn alloy, solder or Au bump. Similarly, the other electrode is connected to a terminal 13b2 of a second wiring pattern 13b through a second conductor bump 38. The other parts are the same as those in FIG. 6 (a).

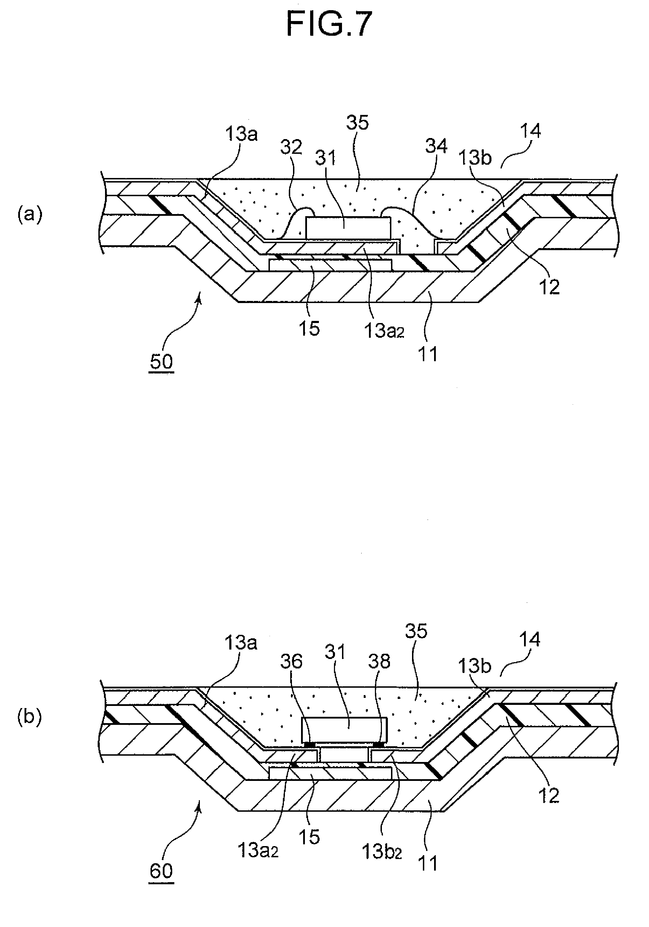

A luminous device shown in FIG. 7 is a portion, which is obtained as a luminous element 31 is mounted in a region of a cavity 14 of the flexible board 20 of the first embodiment, and then divided into every luminous-body flexible board. In the case of a luminous device 50 shown in FIG. 7 (a), within the cavity 14, the luminous element 31 is mounted face-up on a mount portion 13a2 of a first wiring pattern 13a, which is disposed on a bump 15 across a liquid crystal polymer insulating layer 12. The other parts are substantially the same as those in FIG. 6 (a). In the case of a luminous device 60 shown in FIG. 7 (b), within the cavity 14, a luminous element 31 is mounted on a bump 15 across a liquid crystal polymer insulating layer 12 in a way that has a flip chip structure. The other parts are substantially the same as those in FIG. 6 (b).

The luminous element 31 is made of a group-III nitride-based compound semiconductor, such as GaN semiconductor. An LED element of a wavelength conversion type, which emits light beams ranging from ultraviolet light to blue light, is used; or alternatively, an LED element or laser element (LD element), which emits light beams ranging from green light to red light or infrared light, may be used.

The sealing resin 35 is preferably made of a clear, colorless epoxy resin, acrylic resin, silicone resin, BT resin or the like. Furthermore, the following material may be preferably added: a material that works as an optical dispersion material in the sealing resin 35, does not cause loss of light emission, and is clear and colorless and high in reflectance. As for such a material, for example, the following can be listed: silicon oxide, aluminum oxide, calcium carbonate, barium oxide, titanium oxide, barium sulfate, epoxy resin, and the like.

If the luminous element 31 is an LED element of a wavelength conversion type, a required fluorescent substance is added to the sealing resin 35. Such a fluorescent substance becomes excited by the light from a semiconductor LED element, and emits light at a wavelength shifted to a long-wavelength side. For example, the following can be listed as examples: aluminate, including A₃B₅O₁₂:M (A: Y, Gd, Lu, Tb or the like B: Al, Ga M: Ce³⁺, Tb³⁺, Eu³⁺, Cr³⁺, Nd³⁺, Er³⁺ or the like), ABO₃:M (A: Y, Gd, Lu, Tb B: Al, Ga M: Ce³⁺, Tb³⁺, Eu³⁺, Cr³⁺, Nd³⁺, Er³⁺), and the like; or orthosilicate, including (Ba, Ca, Eu)ₓSi_{y}O_{z}:Eu²⁺ and the like.

Then, for example, a fluorescent substance of a YAG (Yttrium Aluminum Garnet) system becomes excited by blue light from a GaN semiconductor LED element in a way that generates yellow colors of fluorescence. In this manner, a mixture of the colors, or white light, is generated. Alternatively, a plurality of fluorescent substances mixed in the sealing resin 35 becomes excited by ultraviolet light from a semiconductor LED element in a way that emits, for example, red, green and blue colors of fluorescence, or three primary colors of colored light. In this manner, white light is generated.

Various other forms of a single luminous device are possible. The above luminous device is used for the case where two external connection electrodes of the luminous element 31 are disposed on one side. As in the case of a luminous element made of a group III-V compound semiconductor, two electrodes of a luminous element may be disposed on both surfaces, i.e. a top and a back surface, of the luminous element. When such a luminous element is mounted, it is possible to use a luminous-body flexible board in which a conductive bump 15 passes through a liquid crystal polymer insulating layer 12 before being electrically connected to a conductor layer 13; or a flexible board in which a bump 15 is connected through a conductive member, such as a conductor bump, which passes through a liquid crystal polymer insulating layer 12 on the bump 15.

When a flexible board in which a bump 15 is electrically connected to a conductor layer 13 is used, a luminous element is mounted on a first wiring pattern 13a, whose back surface is electrically connected to the bump 15, with the use of a conductive paste such as Ag, for example. Then, one electrode on the top surface thereof is electrically connected to a second wiring pattern 13b through a bonding wire. In a single luminous body in which such a luminous element is mounted, a metal substrate 11 offers a heat-release function of the luminous element, and also functions as a luminous body terminal.

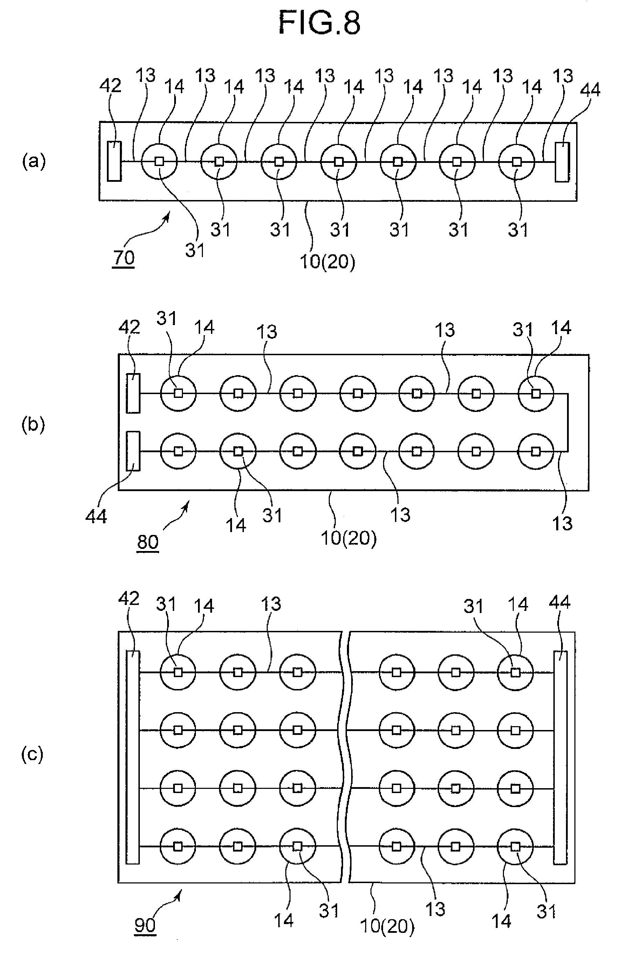

The following describes a luminous-body flexible board in which a plurality of luminous elements are arranged and mounted on a flexible board of the embodiment. A luminous device shown in FIG. 8 can be obtained as luminous elements are mounted in a plurality of cavities 14 arranged on a luminous-body flexible board of the present invention and as the luminous-body flexible board is divided into individual pieces of a predetermined size.

For example, a luminous-body flexible board 70 shown in FIG. 8 (a) has a structure in which luminous elements 31 are mounted in a plurality of cavities 14 of the flexible board 10 or 20, with a required number (seven in the diagram) of luminous elements 31 arranged in series in a one-dimensional manner. The luminous elements 31 are connected in series through the conductor layer 13, and can be supplied with electricity from the outside via a first luminous body terminal 42 and a second luminous body terminal 44.

A luminous-body flexible board 80 shown in FIG. 8 (b) has a structure in which a required number (14 in the diagram) of luminous elements 31 are arranged in series in a one-dimensional manner as in those shown in FIG. 8 (a). However, the array thereof is folded back in the middle. A first luminous body terminal 42 and a second luminous body terminal 44 are disposed at one end of the luminous-body flexible board 80. In the case of FIG. 8 (b), the array may be folded back once or a plurality of times.

For example, a luminous-body flexible board 90 shown in FIG. 8 (c) has a structure in which luminous elements 31 are mounted in a plurality of cavities 14 of the flexible board 10 or 20, with a required number of luminous elements 31 arranged in series and parallel in a two-dimensional manner. In this case, the luminous-body flexible board 70, each of which includes a plurality of luminous elements 31 arranged in a one-dimensional direction as shown in FIG. 8 (a), are so integrated as to be electrically connected in parallel. A required number of luminous elements 31 arranged in a two-dimensional way as described above are connected through the conductor layer 13, and can be supplied with electricity from the outside via a first luminous body terminal 42 and a second luminous body terminal 44.

Various other forms of a luminous-body flexible board are possible. For example, luminous elements 31 that emit different colors of light may be integrated on a luminous-body flexible board. Then, the luminous elements emit colored-light three primary colors of visible light, or red, green and blue light, allowing white light to be extracted. In this case, for the sealing resin 35, for example, the use of the following resins is especially preferred: a clear, colorless epoxy resin, acrylic resin, and silicone resin.

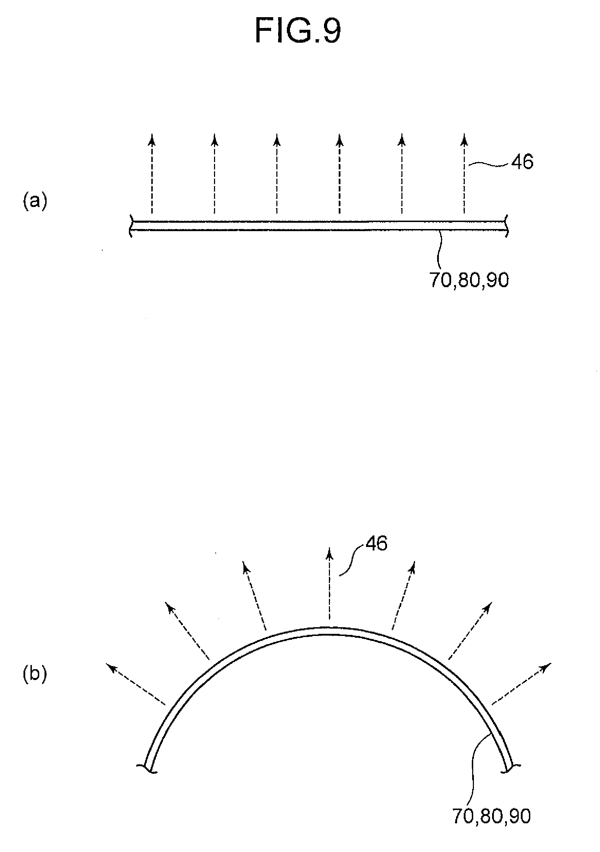

The luminous-body flexible board in a display device or illuminating device makes easier the plane emission of light from a curved surface that for example appears to be a spherical or cylindrical surface, as well as the plane emission of light from a two-dimensional surface. In the case of FIG. 9 (a), a luminous-body flexible board 70, 80 or 90 is attached to a display device or illuminating device in a way that forms a flat surface. In this case, for example, at the luminous-body flexible board 90, a large amount of outgoing light 46 can be easily obtained.

In the case of FIG. 9 (b), the luminous-body flexible board 70, 80 or 90 is flexible and can be freely changed into any shape. Therefore, in a display device or illuminating device, the outgoing light 46 from a curved surface that appears to be a cylindrical surface can be easily obtained. In the case of FIG. 9 (b), the luminous-body flexible board 70, 80 or 90 is attached to a display device or illuminating device in a way that forms a cylinder.

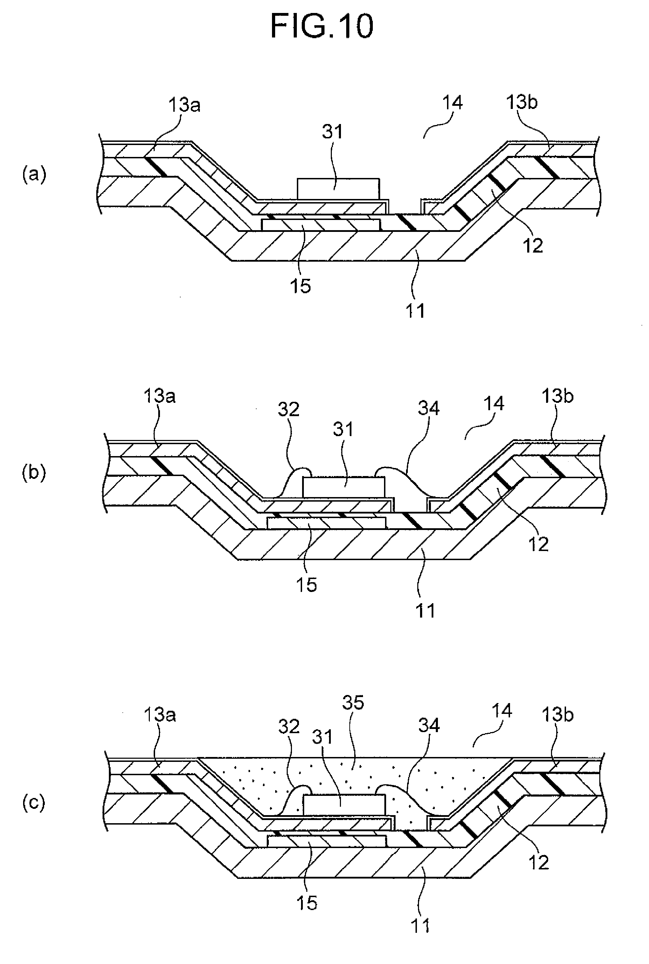

The following describes one example of a method of producing the luminous device. In this case, what is described is the case of a luminous device where a luminous element is mounted on the flexible board 20 illustrated in FIG. 2. In the case of the flexible board 20 that is produced by the method illustrated in FIG. 3, as shown in FIG. 10 (a), with the use of conductive or non-conductive paste, a luminous element 31 is bonded to and mounted on the first wiring pattern 13a in the cavity 14. In this case, for example, if the flexible board 20 is made of a sapphire substrate as in the case of the back surface of a GaN semiconductor and has insulation properties, the conductive or non-conductive paste is used. If the flexible board 20 has conductivity as in the case of the back surface of a GaP, GaAsP or GaAlAs semiconductor, the conductive paste is used.

As shown in FIG. 10 (b), for example, if two electrodes are disposed on one side as in the case of the luminous element 31 of the GaN semiconductor, a first wire 32 and a second wire 34 are used to bond the electrodes to the first wiring pattern 13a and the second wiring pattern 13b. The wires are for example made of an Au fine wire or Al fine wire.

Then, as shown in FIG. 10 (c), the luminous element 31, which is mounted in the cavity 14 of the flexible board 20, the first wire 32, the second wire 34 and the like are sealed with the sealing resin 35. The sealing resin is thermally cured as a heat process is carried out for several hours at about 100 to 150 °C, for example; a thermosetting resin is preferably used. At such a temperature, the liquid crystal polymer insulating layer 12 whose glass transition point Tg or melting point Tm is 200 °C or more can be so designed that the characteristic changes thereof do not take place at all. In this manner, a required number of luminous elements 31 are mounted in regions of a plurality of cavities 14 on the flexible board 20.

The sealing resin 35 is bonded to the resin of the liquid crystal polymer insulating layer 12 in the cavity 14, preventing a separation thereof or any other trouble from happening and making extremely high levels of hermetic sealing possible. As a result, a highly reliable luminous device can be obtained.

Then, the flexible board 20 on which luminous elements 31 are mounted are divided into individual pieces of a required shape. In this manner, for example, the luminous-body flexible boards illustrated in FIGS. 6 to 8 can be obtained.

In the luminous device of the present embodiment, the metal substrate 11 functions as a radiator plate; when the luminous element 31 thereof is in operation, the heat generated is released via the metal substrate 11 in an efficient manner. The heat from the luminous element 31 that is mounted face-up is transferred to the first wiring pattern 13a from the back surface thereof and the first wire 32. Then, the heat is transferred to the bump 15 or metal substrate 11 via the thinly-formed liquid crystal polymer insulating layer 12. In the case of the luminous element 31 that is mounted face-down as in the case of implementation of a flip chip structure, the heat is transferred to the metal substrate 11 via the first conductor bump 36, the first wiring pattern 13a and the liquid crystal polymer insulating layer 12 in that order. If a bump 15 or any other conductive member is so formed as to pass through the liquid crystal polymer insulating layer 12, the heat generated is transferred to the metal substrate 11 directly from the first wiring pattern 13a.

In the cavity 14 on which the luminous element 31 is mounted, the metal substrate 11 is bonded and joined to the back surface of the liquid crystal polymer insulating layer 12 in a way that forms a convex shape to cover the underside of the package. Therefore, it is possible to release the transferred heat in an efficient manner. In this manner, the luminous device of the present embodiment has heat-release performance high enough to handle higher luminance or higher light intensity.

Moreover, the metal substrate 11 reflects the light from the luminous element 31 at the side-face portions 14b of the cavity 14 and a portion of the bottom-face portion 14a so that the light travels in an anterior direction of the luminous device from the back surface of the liquid crystal polymer insulating layer 12; the luminance of the luminous device is increased.

According to the present embodiment, in the luminous device, the liquid crystal polymer insulating layer 12 shows excellent characteristics. The liquid crystal polymer insulating layer 12 has high light reflectance over a wide wavelength range, as well as high temperature resistance. Accordingly, at the side-face portions 14b of the cavity 14 and a portion of the bottom-face portion 14a, the light of the luminous element 31 can be extracted in an anterior direction of the luminous device in an efficient manner, and it becomes easier to increase the luminance of the luminous device.

Moreover, the thermal conductivity thereof is 10 or more times greater than a high-heat-resistance polyimide resin, for example. Because of low dielectric constant and high insulation resistance thereof, it is possible to make the liquid crystal polymer insulating layer 12 thinner. As a result, there is an increase in the efficiency of transferring heat from the luminous element 31 to the metal substrate 11, which is joined to the liquid crystal polymer insulating layer 12. Furthermore, since the liquid crystal polymer insulating layer 12 has high resistance to ultraviolet irradiation, it is possible to realize a luminous device having high light intensity of white light with the use of a wavelength-conversion-type LED element that emits ultraviolet rays, for example.

In that manner, the luminous device of the present embodiment maintains high reliability even in the case of higher luminance or higher light intensity; it becomes easier to make the life thereof longer.

Moreover, the luminous-body flexible board of the present embodiment is flexible and can freely be changed into any shape. Therefore, in a display device or illuminating device, it is possible to easily obtain a desired type of plane emission of light, such as a curved surface that for example appears to be a spherical or cylindrical surface, or a two-dimensional surface.

A plurality of luminous devices can be integrated on a large original flexible board at high densities in manufacturing process. Therefore, it is possible to realize a compact, low-cost luminous device suitable for higher light intensity.

Incidentally, for convenience' sake, the "upper surface" and the "lower surface" are used for description in the specification. However, the "upper surface" and the "lower surface" just mean opposite sides, not upper and lower portions in space.

The above has described preferred embodiments of the present invention. However, the above-described embodiments do not limit the present invention. It should be apparent to those of ordinary skill in the art that various modifications and changes may be made to the specific embodiments without departing from the spirit and scope of the present invention.

According to the above embodiments, what is described is the case where a luminous element is mounted on a bottom-face portion of a cavity on a flexible board. Alternatively, a luminous element may be for example mounted on a bottom-face portion via an attached component thereof, such as a bearing member or fixed member, and be mounted together with such surface mounted components. Moreover, a plurality of cavities may not be formed at regular intervals but at random on a flexible board.

Moreover, as for the production of a luminous device of the above embodiments, what is described is the case where a process of dividing a luminous-body flexible board into individual pieces comes after a resin-sealing process. However, after the dividing process, processes of mounting a luminous element on a luminous-element flexible board, of wire bonding with metallic fine wires and of a resin-sealing may come.

## Claims

1. A luminous-body flexible board comprising a flexible board (10) including a metal substrate (11), an insulating layer (12) and a conductor layer (13),
**characterized in that**
the metal substrate (11) is a bendable plate,
the insulating layer (12) is of liquid crystal polymer and of which one surface is joined directly to the metal substrate (11) and
a conductor layer (13) is joined to the other surface of the insulating layer (12) and formed in a wiring pattern; and
the flexible board (10) has a plurality of cavities (14) dented on a side of the conductor layer (13) and protruded on a side of the metal substrate (11), being arranged in juxtaposition and configured to be mounted a luminous element (31) respectively therein.

2. The luminous-body flexible board according to claim 1, wherein
the cavity (14) is formed into the shape of a dish, and has a bottom-face portion (14a) and a side-face portion (14b).

3. The luminous-body flexible board according to claim 2, wherein
the cavity is formed into the shape of a dish by a draw forming.

4. The luminous-body flexible board according to claim 2, wherein
the metal substrate (11) includes a bump 15) protruded on the metal substrate (11) in the bottom-face portion (14a) and embedded in the insulating layer (12).

5. The luminous-body flexible board according to claim 2 or 3, wherein
the metal substrate (11) located with the side-face portion (14b) of the cavity (14) is formed into a corrugated pattern.

6. The luminous-body flexible board according to claim 1, wherein:
the flexible board (10) is a flexible laminated body in which the metal substrate (11) made of a metal foil, the insulating layer (12) made of a liquid crystal polymer film and the conductor layer (13) are stacked in this order;
the flexible laminated body comprises a dish-shaped cavity (14) having a dented portion (14A) with a bottom-face portion (14a) and a side-face portion (14b) on a side of the insulating layer, and having a convex portion (14B) protruded on a side of the metal substrate; and
the conductor layer (13) has a mount portion (13a2) arranged on the bottom-face portion (14a) to which a luminous element (31) is fixed.

7. The luminous-body flexible board according to claim 6, wherein
the metal substrate (11) is 50 µm to 300 µm in thickness, the liquid crystal polymer film (12) is 15 µm to 100 µm in thickness, and the conductor layer (13) is made of metal foil and is 10 µm to 35 µm in thickness.

8. A luminous device comprising a luminous-body flexible board according to claim 1 or 6 and luminous elements, wherein
the luminous elements (31) are mounted in the cavities (14) and sealed by a translucent insulator (35), and the luminous-body flexible board is bent.
